# EUROPEAN PATENT SPECIFICATION

(11) **EP 3 675 177 B1**
(45) Date of publication and mention of the grant of the patent: **04.11.2026**
(21) Application number: 19216453.1
(22) Date of filing: 16.12.2019
(51) Int. Cl.: H10K 59/124, H10K 59/80, H10K 59/131, H10K 59/65, H10K 59/122

(54) **DISPLAY DEVICE**
ANZEIGEVORRICHTUNG
DISPOSITIF D'AFFICHAGE

(30) Priority: 27.12.2018 KR 20180170527
(43) Date of publication of application: 01.07.2020
(73) Proprietor: LG Display Co., Ltd., Yeongdeungpo-gu Seoul 07336 (KR)
(72) Inventor: LIM, SangHyun, 10845 Gyeonggi-do (KR); KANG, MinJi, 10845 Gyeonggi-do (KR); NA, SeHwan, 10845 Gyeonggi-do (KR)
(74) Representative: Ter Meer und Partner mbB

(56) References cited:
- EP-A1- 3 588 574
- EP-A1- 3 633 751
- EP-A2- 3 486 962
- US-A1- 2017 148 856
- US-A1- 2018 151 834
- US-A1- 2018 183 015
- US-B2- 9 632 487

## Description

This application claims the benefit of the Korean Patent Application No. 10-2018-0170527 filed on December 27, 2018.

### BACKGROUND

### Field of the Invention

The present disclosure relates to a display device, and more particularly, to a display device with a camera provided therein.

### Discussion of the Related Art

A display apparatus includes various display devices such as a liquid crystal display device or an organic light emitting device in a display area. In these display devices, a method for applying various applications by the use of camera provided inside the display device and configured to interwork with the display area has been studied.

In order to provide the camera inside the display device, a camera hole for placing the camera in the display device has to be provided. Generally, the camera hole is obtained by a process of removing some areas from the display device through a laser-beam irradiation.

However, damages such as cracks may be generated for the process of removing some areas from the display device through the laser-beam irradiation. Furthermore, the cracks may extend to the display area so that it may cause problems such as degradation of picture quality and deterioration of the display device.

EP 3 486 962 A2 relates to a display panel which includes a base substrate including a front surface and a rear surface and having first and second holes, and a pixel layer on the base substrate. A display area is defined in the front surface. The first hole overlaps with the display area and penetrates the front and rear surfaces. The second hole overlaps with the display area, is adjacent to the first hole, and is recessed from the front surface. The base substrate includes a first base layer including the rear surface, a first barrier layer on the first base layer and including first inorganic films having a first refractive index, and second inorganic films having a second refractive index, a second base layer on the first barrier layer, and a second barrier layer on the second base layer and including the front surface. The first and second inorganic films are alternately stacked.

EP 3 588 574 A1 relates to a display device which includes a substrate, a circuit layer on the substrate, a display layer on the circuit layer, at least one hole in a display area of the substrate that penetrates the substrate, the circuit layer, and the display layer, and at least two grooves that surround the at least one hole, where each of the at least two grooves has an under-cut structure. The substrate includes a first substrate, a first inorganic layer, a second substrate, and a second inorganic layer, which are sequentially stacked, and each of the at least two grooves extends down from the display layer into the second substrate.

US 9 632 487 B2 relates to an organic light emitting display device including a substrate having a display area in which a plurality of plurality pixels are disposed, a non-display area outside of the display area, and at least one open hole area defined between the plurality of pixels, and a stacked layer structure disposed on the substrate and defining the plurality of pixels in the display area, the stacked layer structure including at least one organic layer, wherein the at least one open hole area includes at least one open hole penetrating through the substrate and at least one partition disposed along a circumference of the at least one open hole between the at least one open hole and the plurality of pixels adjacent thereto to separate the at least one organic layer from a corresponding layer that extends to the at least one open hole.

US 2018/0151834 A1 relates to a display device including a substrate, a plurality of pixels above the substrate, each of the pixels including a light emitting element, a display region including the plurality of pixels, a thin film transistor which each of the plurality of pixels includes, a protective film including a first inorganic insulating material and located between the thin film transistor and the light emitting element, a sealing film including a second inorganic insulating material and covering the light emitting element, and at least one through hole located in the display region and passing through the substrate, the protective film, and the sealing film, wherein the second inorganic insulating material is in direct contact with the protective film in a first region located between the through hole and the pixels.

US 2017/148856 A1 relates to an organic light-emitting display including a substrate, an insulating layer on the substrate, the substrate and the insulating layer having an opening therethrough penetrating, a pixel array on the insulating layer, the pixel array including a plurality of pixels that surround the opening, a first pixel adjacent to the opening from among the plurality of pixels includes a pixel electrode layer, an intermediate layer on the pixel electrode layer, and an opposite electrode layer on the intermediate layer, and a stepped portion on the substrate and adjacent to the opening, the stepped portion having an under-cut step, wherein the intermediate layer including an organic emission layer, and wherein at least one of the intermediate layer and the opposite electrode layer extends toward the opening and is disconnected by the stepped portion.

US 2018/183015 A1 relates to a display apparatus which includes a flexible substrate, a thin-film transistor unit, and a light-emitting unit. The flexible substrate includes a display area has a first area, a peripheral area which is adjacent to the display area, and a first penetrating portion corresponding to the first area. The thin-film transistor unit is in the display area and at least a portion of the peripheral area. The thin-film transistor unit includes a thin-film transistor and an insulation layer and has a second penetrating portion at a location corresponding to the first penetrating portion. The light-emitting unit is on the thin-film transistor unit and includes a pixel electrode, an intermediate layer including an emission layer, and a counter electrode.

EP 3 633 751 A1 is prior art according to Art. 54(3) EPC and relates to a display device which includes a substrate including a display area and a non-display area and a hole defined through the substrate along the thickness direction in the display area. The display device further includes a first sealing portion disposed on the substrate in the non-display area, and a second sealing portion disposed on the substrate and enclosing the hole. The display device includes a source electrode, a drain electrode, and a heat transfer layer, which are all disposed on the same insulating interlayer. The heat transfer layer may improve adhesion between the first sealing portion 881 and the insulating layer, and is not in contact with the hole.

### SUMMARY

The present disclosure has been made in view of the above problems, and it is an object of the present disclosure to provide a display device which is capable of preventing damages such as cracks, which might be generated when a camera hole is formed, from extending to a display area.

The object is solved by the features of the independent claim. Preferred embodiments are given in the dependent claims. Any "aspect", "example" and "embodiment" of the description not falling within the scope of the claims does not form part of the invention and is provided for illustrative purposes only.

In accordance with an aspect of the present invention, the above and other objects can be accomplished by the provision of a display device comprising a hole area, a buffer area configured to at least partially surround the hole area, and a display area configured to surround the buffer area, wherein the display area includes a thin film transistor including a source electrode, and a drain electrode, which are provided on an insulating interlayer, wherein the buffer area includes a damage preventing portion configured to prevent damages generated in a process of forming the hole area, from extending to the display area.

The damage preventing portion is formed of the same material as that of the source and drain electrodes, and is provided on the insulating interlayer.

The damage preventing portion is provided in a same layer as that of the source electrode and drain electrode of the display area.

The damage preventing portion includes a first layer, a second layer on the first layer, and a third layer on the second layer.

Each of the source electrode and the drain electrode has a three-layered structure in the same manner as the damage preventing portion.

In accordance with another aspect of the present disclosure, not forming part of the claimed invention, there is provided a display device comprising a substrate, and a circuit device layer on the substrate, wherein the display device includes a hole area configured to penetrate through the substrate and the circuit device layer, and a buffer area configured to surround the hole area, a damage preventing portion is provided in the buffer area. Preferably, one lateral surface of the damage preventing portion confronting the hole area may be formed in a groove structure toward a direction being farther away from the camera area.

According to one embodiment of the present disclosure, the buffer area may be provided to surround the hole area

The damage preventing portion is provided in the buffer area so that it is possible to prevent damages generated when the hole area is formed, from extending to the display area.

The damage preventing portion is formed of the same material as that of the source and drain electrodes in the display area, and/or may be manufactured by the same patterning process as that of the source and drain electrodes in the display area.

Thereby it is unnecessary to carry out an additional process for forming the damage preventing portion, thereby realizing simplified manufacturing process and minimizing the increase of manufacturing cost.

Also, according to one embodiment of the present disclosure, the camera area and the buffer area may be surrounded by the display area, whereby the size of the display area may be increased in comparison to the case where the camera area and the buffer area are surrounded by the non-display area positioned in the periphery of the display area.

The damage preventing portion includes a first layer, a second layer on the first layer, and a third layer on the second layer.

Preferably, a first lateral surface of the second layer confronting the hole area may be formed in a groove structure toward a direction being farther away from the hole area.

Preferably, a width between the first lateral surface of the second layer and a second lateral surface corresponding to an opposite lateral surface to the first lateral surface of the second layer may be gradually decreased as it goes from its upper portion to its central portion.

Preferably, it may be then gradually increased as it goes from its central portion to its lower portion.

Preferably, the second lateral surface of the second layer, which corresponds to the opposite lateral surface to the first lateral surface, may be formed in a groove structure toward a direction being closer to the hole area.

Preferably, a thickness of the second layer may be relatively larger than a thickness in each of the first layer and the third layer.

Preferably, a camera may be provided in the hole area.

Preferably, the hole area may be provided in the center with respect to a first axis of the display area on the plane.

Preferably, the hole area may be provided to be close to one end of the display area in an area between a center of the display area and the one end of the display area with respect to a first axis of the display area on the plane.

Preferably, the buffer area may include a substrate, an inorganic insulating layer on the substrate, an organic insulating layer on the inorganic insulating layer, an electrode on the organic insulating layer, and an encapsulation layer on the electrode, and the electrode and the encapsulation layer are provided on the damage preventing portion, and the damage preventing portion is not overlapped with the organic insulating layer.

Preferably, the buffer area may further include a dam structure provided on the organic insulating layer.

Preferably, the encapsulation layer may include at least one of a first encapsulation layer, a second encapsulation layer on the first encapsulation layer, and a third encapsulation layer on the second encapsulation layer.

Preferably, a lower surface of the third encapsulation layer may be brought into contact with an upper surface of the first encapsulation layer in the overlap area between the encapsulation layer and the dam structure.

Preferably, the dam structure may include at least one of a first dam structure, and a second dam structure on the first dam structure.

Preferably, the first dam structure may be provided at the same height as that of a bank provided in the display area.

Preferably, the first dam structure may be formed of the same material as that of the bank provided in the display area.

Preferably, the damage preventing portion may contact the hole area.

Preferably, the display device may further comprise a substrate, an electrode on the substrate, and an encapsulation layer on the electrode additionally provided in an area between the damage preventing portion and the hole area.

Preferably, the camera area may be formed in at least one of a circular shape, an oval shape, or a polygonal shape on the plane, and the buffer area may be formed in a circular doughnut shape, an oval-type doughnut shape, or a polygonal doughnut shape.

Preferably, a display device may comprise a substrate, and a circuit device layer on the substrate.

Preferably, the display device may include a hole configured to penetrate through the substrate and the circuit device layer, and a buffer area configured to surround the hole area.

Preferably, one lateral surface of the damage preventing portion confronting the hole area may be provided in a groove structure toward a direction being farther away from the camera area.

Preferably, the groove structure may be provided with a curved-line structure having an inclination in the one lateral surface of the damage preventing portion.

Preferably, the other lateral surface of the damage preventing portion, which corresponds to an opposite lateral surface to the one lateral surface of the damage preventing portion, may be provided in a groove structure toward a direction being closer to the hole area.

Preferably, a width between the one lateral surface of the damage preventing portion and the other lateral surface of the damage preventing portion corresponding to an opposite lateral surface to the one lateral surface of the damage preventing portion may be gradually decreased as it goes from its upper portion to its central portion, and/or may be then gradually increased as it goes from its central portion to its lower portion.

Preferably, the buffer area may include an inorganic insulating layer on the substrate, an organic insulating layer on the inorganic insulating layer, an electrode on the organic insulating layer, and an encapsulation layer on the electrode.

Preferably, the damage preventing portion may not overlapped with the organic insulating layer, and the electrode and the encapsulation layer may be provided on the damage preventing portion.

Preferably, a camera is provided in the hole area.

Preferably, the inner form of the buffer area is the same as the outer form of the camera area.

Preferably, the inner form of the buffer area is different than the outer form of the camera area.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a rough plane view illustrating a display device according to one embodiment of the present disclosure;
FIG. 2 is a rough cross-sectional view illustrating the display device according to one embodiment of the present disclosure, which corresponds to a cross section along A-B of FIG. 1;
FIG. 3 is a rough cross-sectional view illustrating a buffer area and a camera area in the display device according to the claimed invention;
FIG. 4 is a rough cross-sectional view illustrating a buffer area and a camera area in a display device according to another embodiment of the present disclosure;
FIG. 5 is a rough cross-sectional view illustrating a display device according to another embodiment of the present disclosure, wherein a camera hole is formed by applying a laser cutting process to the display device of FIG. 2, and a camera is placed in the camera hole;
FIG. 6 is a rough cross-sectional view illustrating a buffer area and a camera area in a display device according to another embodiment of the present disclosure;
FIG. 7 is a rough cross-sectional view illustrating a buffer area and a camera area in a display device according to another embodiment of the present disclosure;
FIG. 8 is a rough cross-sectional view illustrating a buffer area and a camera area in a display device according to another embodiment of the present disclosure;
FIG. 9 is a rough cross-sectional view illustrating a buffer area and a camera area in a display device according to another embodiment of the present disclosure;
FIG. 10 is a rough cross-sectional view illustrating a display device according to another embodiment of the present disclosure;
FIGs. 11 to 13 are rough plane views illustrating display devices according to various embodiments of the present disclosure; and
FIGs. 14 and 15 are rough plane views illustrating display devices according to various embodiments of the present disclosure.

### DETAILED DESCRIPTION OF THE DISCLOSURE

Advantages and features of the present disclosure, and implementation methods thereof will be clarified through following embodiments described with reference to the accompanying drawings. The present disclosure may, however, be embodied in different forms and should not be construed as limited to the embodiments set forth herein. Rather, these embodiments are provided so that this disclosure will be thorough and complete, and will fully convey the scope of the present disclosure to those skilled in the art. Further, the present disclosure is only defined by scopes of claims.

A shape, a size, a ratio, an angle, and a number disclosed in the drawings for describing embodiments of the present disclosure are merely an example, and thus, the present disclosure is not limited to the illustrated details. Like reference numerals refer to like elements throughout the specification. In the following description, when the detailed description of the relevant known function or configuration is determined to unnecessarily obscure the important point of the present disclosure, the detailed description will be omitted.

In a case where 'comprise', 'have', and 'include' described in the present specification are used, another part may be added unless 'only~' is used. The terms of a singular form may include plural forms unless referred to the contrary.

In construing an element, the element is construed as including an error range although there is no explicit description.

In describing a position relationship, for example, when the position relationship is described as 'upon~', 'above~', 'below~', and 'next to~', one or more portions may be arranged between two other portions unless 'just' or 'direct' is used.

In describing a time relationship, for example, when the temporal order is described as "after~', 'subsequent~', 'next~', and 'before~', a case which is not continuous may be included unless 'just' or 'direct' is used.

It will be understood that, although the terms "first", "second", etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

It should be understood that the term "at least one" includes all combinations related with any one item. For example, "at least one among a first element, a second element and a third element" may include all combinations of two or more elements selected from the first, second and third elements as well as each element of the first, second and third elements.

Features of various embodiments of the present disclosure may be partially or overall coupled to or combined with each other, and may be variously inter-operated with each other and driven technically as those skilled in the art can sufficiently understand. The embodiments of the present disclosure may be carried out independently from each other, or may be carried out together in co-dependent relationship.

Hereinafter, the preferred embodiments of the present disclosure will be described in detail with reference to the accompanying drawings. Any "aspect", "example" and "embodiment" of the description not falling within the scope of the claims does not form part of the invention and is provided for illustrative purposes only.

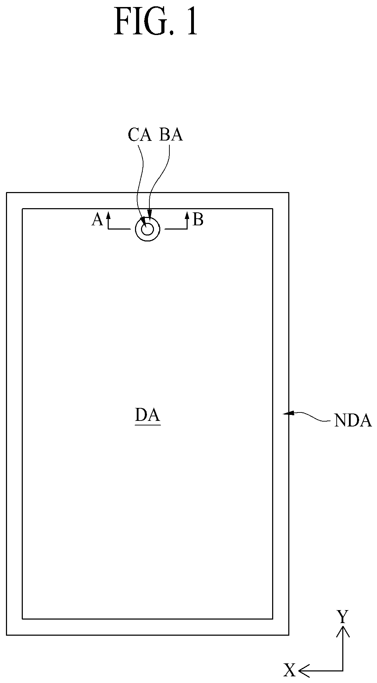

As shown in FIG. 1, a display device according to one embodiment of the present disclosure includes a display area (DA), a non-display area (NDA), a hole area (CA), and a buffer area (BA).

The display area (DA) is provided in a central portion of the display device, and an image is displayed on the display area (DA). In the display area (DA), various display devices which are generally known to those in the art, for example, an organic light emitting device or a liquid crystal display device may be provided therein. This image display device includes a plurality of pixels, wherein the plurality of pixels include a plurality of signal lines and a plurality of thin film transistors.

The non-display area (NDA) is provided in the periphery of the display area (DA). In the non-display area (NDA), there are a driver configured to supply various signals to the plurality of signal lines in the display area (DA), and a link portion configured to connect the driver with the plurality of signal lines. The driver includes a gate driver configured to supply a gate signal to a gate line, and a data driver configured to supply a data signal to a data line.

The hole area (CA) is provided inside the display area (DA). The hole area (CA) corresponds to the area where a camera is to be positioned, and an image is not displayed on the hole area (CA). The hole area (CA) may be formed in a circular shape.

The buffer area (BA) is provided between the hole area (CA) and the display area (DA). Especially, the buffer area (BA) is provided to at least partly surround the peripheral area of the hole area (CA) so that the buffer area (BA) may be formed in a shape corresponding to a shape of the hole area (CA). Preferably, it surrounds the hole area (CA) completely. For example, the hole area (CA) is formed in a circle shape, the buffer area (BA) may be formed in a circular doughnut or tube shape.

As the buffer area (BA) separates the hole area (CA) and the display area (DA) from each other, it is possible to prevent the hole area (CA) from being influenced by the display area (DA), and also to prevent the display area (DA) from being influenced by the hole area (CA). In detail, the buffer area (BA) prevents an organic encapsulation layer formed in the display area (DA) from being permeated into the hole area (CA), and also prevents damages such as cracks which might be generated during a process of forming the hole area (CA) from being transferred to the display area (DA).

On the plane view, the hole area (CA) and the buffer area (BA) may be positioned in the center with respect to a first axis (for example, X-axis) of the display area (DA), or may be positioned between the center and one end (for example, upper end or lower end) with respect to a second axis (for example, Y-axis) of the display area, wherein the second axis is perpendicular to the first axis, especially, may be positioned adjacent to one end, but not necessarily.

The buffer area (BA) and the hole area (CA) may be provided inside the display area (DA) while being spaced apart from the non-display area (NDA). That is, the buffer area (BA) is surrounded by the display area (DA), and the hole area (CA) is surrounded by the display area (DA) while the buffer area (BA) is interposed in-between.

When the hole area (CA) and the buffer area (BA) are provided in the non-display area (NDA), a size of the non-display area (NDA) is increased in the Y-axis direction, whereby a size of the display area (DA) is decreased by the increased size of the non-display area (NDA).

Meanwhile, according to one embodiment of the present disclosure, the hole area (CA) and the buffer area (BA) are surrounded by the display area (DA) so that a size of the display area (DA) is not decreased in the Y-axis direction.

In this disclosure, the hole area (CA) corresponds to the area where a hole for a camera to be placed therein is formed. Hereinafter, it will be explained on assumption that the hole area (CA) is a camera area (CA) where a camera is placed therein.

Hereinafter, the display device according to one embodiment of the present disclosure will be described in detail with reference to the cross-sectional structure.

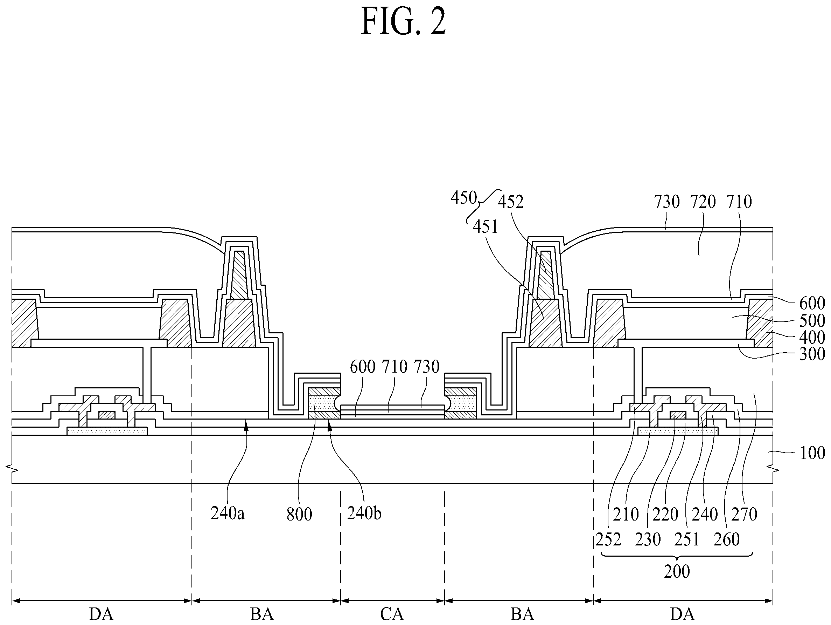

FIG. 2 is a rough cross-sectional view illustrating a display device according to one embodiment of the present disclosure, which corresponds to the cross-sectional view along A-B of FIG. 1. FIG. 2 illustrates the display device including an organic light emitting device. Also, FIG. 2 shows the state before a camera hole is formed by a laser cutting process.

As shown in FIG. 2, the display device according to one embodiment of the present disclosure includes a display area (DA), a buffer area (BA), and a camera area (CA).

First, the display area (DA) will be described. On the display area (DA) of a substrate 100, there are a circuit device layer 200, a first electrode 300, a bank 400, an emission layer 500, a second electrode 600, and encapsulation layers 710, 720 and 730.

The substrate 100 may be formed of transparent glass or plastic, but not limited to these materials. If the display device according to one embodiment of the present disclosure includes a top emission type organic light emitting device, the substrate 100 may be formed of an opaque material.

The circuit device layer 200 is provided on the substrate 100. In the circuit device layer 200, a circuit device including various signal lines, a thin film transistor, and a capacitor is provided for each pixel. The plurality of signal lines may include a gate line, a data line, a power line, and a reference line. The plurality of thin film transistors may include a switching thin film transistor, a driving thin film transistor, and a sensing thin film transistor. In FIG. 2, only the driving thin film transistor is shown in the circuit device layer 200.

The circuit device layer 200 includes an active layer 210, a gate insulating layer 220, a gate electrode 230, an insulating interlayer 240, a source electrode 251, a drain electrode 252, a passivation layer 260, and a planarization layer 270.

The active layer 210 is patterned on the substrate 100. The gate insulating layer 220 is formed between the active layer 210 and the gate electrode 230. The gate electrode 230 is overlapped with the active layer 210 while being formed on the gate insulating layer 220. The insulating interlayer 240 is provided between the gate electrode 230 and the source electrode 251, and also provided between the gate electrode 230 and the drain electrode 252. The source electrode 251 and the drain electrode 252 confront each other on the insulating interlayer 240. Also, the source electrode 251 and the drain electrode 252 are respectively connected with the active layer 210 through a contact hole provided in the insulating interlayer 240 and the gate insulating layer 220. The passivation layer 260 is formed on the source electrode 251 and the drain electrode 252, and the planarization layer 270 is formed on the passivation layer 260. Each of the gate insulating layer 220, the insulating interlayer 240, and the passivation layer 260 is formed of an inorganic insulating layer having a relatively small thickness, and the planarization layer 270 is formed of an organic insulating layer having a relatively large thickness. This structure of the driving thin film transistor may be changed in various types generally known to those in the art.

The first electrode 300 is patterned for each pixel while being provided on the circuit device layer 200. The first electrode 300 may function as an anode electrode of the organic light emitting device. The first electrode 300 is connected with the source electrode 251 of the driving thin film transistor through a contact hole provided in the passivation layer 260 and the planarization layer 270. If needed, the first electrode 300 may be connected with the drain electrode 252 of the driving thin film transistor through a contact hole provided in the passivation layer 260 and the planarization layer 270.

The bank 400 is formed in the boundaries between each of the pixels while being provided on the circuit device layer 200 and being configured to cover the edges of the first electrode 300. An exposed portion of the first electrode 300, which is exposed without being covered by the bank 400, forms an emission area.

The emission layer 500 is formed on the first electrode 300. The emission layer 500 may be provided to emit white light. To this end, the emission layer 500 may comprise a plurality of stacks for emitting different-colored light. For example, the emission layer 500 may include a first stack for emitting blue colored light, a second stack for emitting yellow-green colored light, and a charge generation layer provided between the first stack and the second stack. The emission layers 500 for emitting white light may be connected with each other in the plurality of pixels. Meanwhile, the emission layer 500 may include a blue emission layer, a green emission layer, and a red emission layer which are patterned while being separated from each other in the plurality of pixels.

The second electrode 600 is provided on the emission layer 500. The second electrode 600 may function as a cathode of the organic light emitting device. The second electrodes 600 may be connected with each other in the plurality of pixels.

The encapsulation layer 710, 720 and 730 is provided on the second electrode 600. The encapsulation layer 710, 720 and 730 may include the first encapsulation layer 710, the second encapsulation layer 720, and the third encapsulation layer 730. The first encapsulation layer 710 is provided on the second electrode 600, the second encapsulation layer 720 is provided on the first encapsulation layer 710, and the third encapsulation layer 730 is provided on the second encapsulation layer 720. The first encapsulation layer 710 and the third encapsulation layer 730 are formed of inorganic insulating layers, and prevent external moisture from being permeated into the emission layer 500. The second encapsulation layer 720 is formed of an organic insulating layer, and absorbs externally-permeated moisture so as to prevent moisture permeation into the emission layer 500. Also, the second encapsulation layer 720 covers an external particle and also absorbs an external shock.

The buffer area (BA) will be described as follows. On the buffer area (BA) of the substrate 100, there are the gate insulating layer 220, the insulating interlayer 240, the passivation layer 260, the planarization layer 270, a dam structure 450, the second electrode 600, the encapsulation layer 710, 720 and 730, and a damage preventing portion 800.

In the buffer area (BA), inorganic insulating layers or organic insulating layers such as the gate insulating layer 220, the insulating interlayer 240, the passivation layer 260, and the planarization layer 270 constituting the circuit device layer 200 may be formed, and the aforementioned thin film transistor is not formed. And, other circuit devices may be not provided in the buffer area (BA).

The gate insulating layer 220 and the insulating interlayer 240 may be provided in the entire buffer area (BA). However, the passivation layer 260 and the planarization layer 270 may be provided in only some areas of the buffer area (BA), but not provided in the remaining areas of the buffer area (BA). Accordingly, a first upper surface 240a of the insulating interlayer 240 in the buffer area (BA) is covered by the passivation layer 260 and the planarization layer 270, and a second upper surface 240b of the insulating interlayer 240 in the buffer area (BA) is exposed without being covered by the passivation layer 260 and the planarization layer 270.

The dam structure 450 is provided on the planarization layer 270. That is, the dam structure 450 is overlapped with the first upper surface 240a of the insulating interlayer 240. The dam structure 450 prevents the second encapsulation layer 720 of the organic material from flowing into the camera area (CA). The second encapsulation layer 720 of a liquid type may be coated onto the first encapsulation layer 710. In this case, if the second encapsulation layer 720 of the liquid type flows to the camera area (CA), a laser cutting process to be performed later in the camera area (CA) might be difficult.

Thus, according to one embodiment of the present disclosure, the dam structure 450 is formed in the buffer area (BA) so that it is possible to prevent the second encapsulation layer 720 from flowing into the camera area (CA). Eventually, according as the second encapsulation layer 720 is not provided in the corresponding areas from the area overlapped with the dam structure 450 to the area overlapped with the damage preventing portion 800, a lower surface of the third encapsulation layer 730 is brought into contact with an upper surface of the first encapsulation layer 710 in the corresponding areas where the second encapsulation layer 720 is not provided.

The dam structure 450 may include a first dam structure 451 and a second dam structure 452. The first dam structure 451 and the bank 400 may be formed of the same material, and may be patterned at the same height. The second dam structure 452 is provided on the first dam structure 451 so that it is possible to increase an entire height of the dam structure 450. A width in a lower surface of the second dam structure 452 may be smaller than a width in an upper surface of the first dam structure 451, but not limited to this structure.

The second electrode 600 may be formed in the entire buffer area (BA). In detail, the second electrode 600 may extend from the area above the upper surface of the planarization layer 270 to the area above the second upper surface 240b of the insulating interlayer 240 and the upper surface of the damage preventing portion 800 along the upper surface of the dam structure 450 and the lateral surface of the planarization layer 270.

Among the encapsulation layers 710, 720 and 730, the second encapsulation layer 720 is blocked by the dam structure 450, whereby the second encapsulation layer 720 may extend only to the front of the dam structure 450, and more particularly, to the front of the dam structure 450 corresponding to an opposite area of the camera area (CA). Meanwhile, the first encapsulation layer 710 and the third encapsulation layers 730 may be provided in the entire buffer area (BA). Accordingly, the first encapsulation layer 710 extends along the upper surface of the second electrode 600 on the upper surface of the second electrode 600, and the third encapsulation layer 730 extends along the upper surface of the first encapsulation layer 710 on the upper surface of the first encapsulation layer 710. Thus, each of the first encapsulation layer 710 and the third encapsulation layer 730 may be overlapped with the planarization layer 270, the dam structure 450, the second upper surface 240b of the insulating interlayer 240, and the damage preventing portion 800.

The damage preventing portion 800 is provided while being in contact with the second upper surface 240b of the insulating interlayer 240. Thus, the damage preventing portion 800 is not overlapped with the planarization layer 270 of the organic insulating layer having the large thickness.

In the same manner as the above source electrode 251 and drain electrode 252 of the display area (DA), the damage preventing portion 800 is provided on the insulating interlayer 240. Thus, the damage preventing portion 800 is formed of the same material as that of the source electrode 251 and the drain electrode 252, and may be patterned by the same process as that of the source electrode 251 and the drain electrode 252. According to the claimed invention, the damage preventing portion 800 is formed of the same material as that of the source electrode 251 and the drain electrode 252, and patterned by the same process as that of the source electrode 251 and the drain electrode 252, whereby it is unnecessary to carry out an additional process for forming the damage preventing portion 800, thereby realizing simplified manufacturing process and minimizing the increase of manufacturing cost.

The damage preventing portion 800 is formed to be in contact with the boundaries between the buffer area (BA) and the camera area (CA). Owing to the damage preventing portion 800, it is possible to prevent damages such as cracks which might be generated in the camera area (CA) from extending to the display area (DA) through the buffer area (BA). In more detail, when the camera hole is formed in the camera area (CA) by the laser cutting process, damages such as cracks might be generated in at least one among the second electrode 600, the first encapsulation layer 710, and the third encapsulation layer 730 formed in the camera area (CA) during the laser cutting process, and the damages such as cracks might extend to the display area (DA) through the buffer area (BA). If the cracks formed in the second electrode 600 extend to the display area (DA), the emission is not smoothly generated in the emission layer 500. Furthermore, if the cracks formed in the first encapsulation layer 710 and the third encapsulation layer 730 extend to the display area (DA), external moisture may be permeated through the generated cracks, whereby it accelerates deterioration of the emission layer 500. Thus, according to one embodiment of the present disclosure, the damage preventing portion 800 is formed in the buffer area (BA) so that it is possible to prevent the cracks, which might occur in the camera area (CA) during the laser cutting process, from extending to the display area (DA).

The damage preventing portion 800 is configured to disconnect (or separate) the second electrode 600, the first encapsulation layer 710, and the third encapsulation layer 730 formed thereon in the buffer area (BA) from the second electrode 600, the first encapsulation layer 710, and the third encapsulation layer 730 formed thereon in the camera area (CA). That is, the second electrode 600, the first encapsulation layer 710, and the third encapsulation layer 730 formed in the buffer area (BA) are disconnected from the second electrode 600, the first encapsulation layer 710, and the third encapsulation layer 730 formed in the camera area (CA) by the use of damage preventing portion 800. Even though the damages such as cracks may occur in at least one among the second electrode 600, the first encapsulation layer 710, and the third encapsulation layer formed in the camera area (CA), the damages can hardly extend to the buffer area (BA).

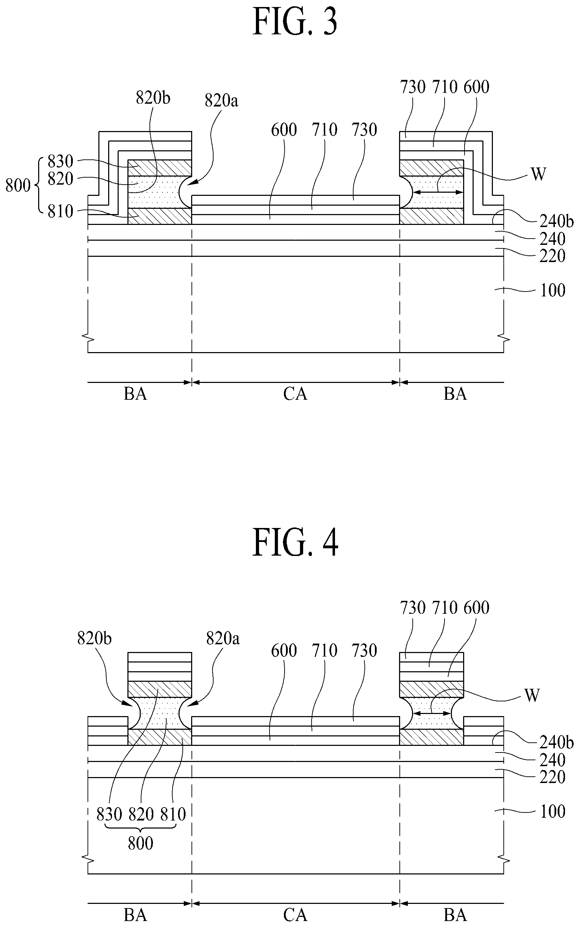

Hereinafter, a structure of the damage preventing portion 800 configured to disconnect the second electrode 600, the first encapsulation layer 710, and the third encapsulation layer 730 formed in the buffer area (BA) from the second electrode 600, the first encapsulation layer 710, and the third encapsulation layer 730 formed in the camera area (CA) according to various embodiments of the present disclosure will be described with reference to FIGs. 3 and 4.

The camera area (CA) will be described as follows. On the camera area (CA) of the substrate 100, there are the gate insulating layer 220, the insulating interlayer 240, the second electrode 600, the first encapsulation layer 710, and the third encapsulation layer 730.

In the camera area (CA), the passivation layer 260 and the planarization layer 270 are not formed so that it facilitates to form the camera hole by the laser cutting process to be performed later. The gate insulating layer 220 and the insulating interlayer 240 formed in the camera area (CA) are respectively connected with the gate insulating layer 220 and the insulating interlayer 240 formed in the buffer area (BA) and the display area (DA). However, the second electrode 600, the first encapsulation layer 710, and the third encapsulation layer 730 formed in the camera area (CA) are not connected with the second electrode 600, the first encapsulation layer 710, and the third encapsulation layer 730 formed in the buffer area (BA) and the display area (DA).

FIG. 3 is a rough cross-sectional view illustrating the buffer area (BA) and the camera area (CA) in the display device according to one embodiment of the present disclosure, which shows the cross-sectional structure of the damage preventing portion 800 according to one embodiment of the present disclosure. FIG. 3 shows the state before the camera hole is formed by the laser cutting process.

As shown in FIG. 3, according to the claimed invention, the damage preventing portion 800 includes a first layer 810, a second layer 820, and a third layer 830.
The second layer 820 is provided on the first layer 810, and the third layer 830 is provided on the second layer 820.

The damage preventing portion 800 is formed of the same material as that of the source electrode 251 and drain electrode 252 of the aforementioned display area (DA), and is provided in the same layer as that of the source electrode 251 and drain electrode 252 of the aforementioned display area (DA), whereby each of the source electrode 251 and the drain electrode 252 has a three-layered structure in the same manner as the damage preventing portion 800. When the damage preventing portion 800 is formed of the same material as that of the source electrode 251 and drain electrode 252, the first layer 810, the second layer 820, and the third layer 830 may be formed of a conductive material. In this case, the first layer 810 and the third layer 830 respectively cover lower and upper surfaces of the second layer 820 so that it is possible to prevent corrosion of the second layer 820. To this end, the first layer 810 and the third layer 830 may be formed of a material with relatively-low oxidation degree and relatively-high corrosion resistance in comparison to the second layer 820. Also, the second layer 820 may be formed of a material with relatively-low resistance (electrical) in comparison to the electrical resistance of the first layer 810 and the third layer 830. In order to lower total resistance in the three-layered structure, a thickness of the second layer 820 is relatively larger than a thickness of each of the first layer 810 and the third layer 830.

Owing to the damage preventing portion 800, the second electrode 600, the first encapsulation layer 710, and the third encapsulation layer 730 provided in the buffer area (BA) are disconnected from the second electrode 600, the first encapsulation layer 710, and the third encapsulation layer 730 provided in the camera area (CA). In detail, the second electrode 600, the first encapsulation layer 710, and the third encapsulation layer 730 provided on the damage preventing portion 800 in the buffer area (BA) are disconnected from the second electrode 600, the first encapsulation layer 710, and the third encapsulation layer 730 provided on the damage preventing portion 800 in the camera area (CA).

To this end, a first lateral surface 820a of the second layer 820 confronting the camera area (CA) is provided in a groove structure toward an inner direction of the second layer 820, and more particularly, toward the direction being gradually farther-away from the camera area (CA). Especially, the groove structure is provided with a curved-line structure having a predetermined inclination in the first lateral surface 820a of the second layer 820.

If the first lateral surface 820a of the second layer 820 is provided in the groove structure, the second electrode 600, the first encapsulation layer 710, and the third encapsulation layer 730 are not sequentially deposited on the groove structure of the first lateral surface 820a of the second layer 820, and may be provided in the disconnected structure or may have a distance to the second layer 820 and its lateral surface 820a.

Meanwhile, a width (W) of the second layer 820, and more particularly, a width (W) between the first lateral surface 820a of the second layer 820 confronting the camera area (CA) and a second lateral surface 820b opposite to the first lateral surface 820a is gradually decreased as it goes from its upper portion to its central portion, and is then gradually increased as it goes from its central portion to its lower portion, whereby it is possible to realize a stable deposition structure in the first layer 810 and the third layer 830 respectively provided below and above the second layer 820.

FIG. 4 is a rough cross-sectional view illustrating a buffer area (BA) and a camera area (CA) in a display device according to another embodiment of the present disclosure, which shows a cross-sectional structure of a damage preventing portion 800 according to another embodiment of the present disclosure. FIG. 4 shows the state before a camera hole is formed by a laser cutting process.

In case of the damage preventing portion 800 of FIG. 4, both a first lateral surface 820a and a second lateral surface 820b in a second layer 820 are formed in groove structures. In this respect, the damage preventing portion of FIG. 4 is different from the damage preventing portion of FIG. 3.

Referring to FIG. 4, the first lateral surface 820a of the second layer 820 confronting a camera area (CA) is provided in the groove structure toward an inner direction, and more particularly, the direction being gradually farther-away from the camera area (CA). Also, the second lateral surface 820b of the second layer 820, which corresponds to the opposite lateral surface to the first lateral surface 820a, is provided in the groove structure toward the inner direction, and more particularly, the direction being gradually close to the camera area (CA). Especially, the groove structure is provided with a curved-line structure having a predetermined inclination in both the first lateral surface 820a and the second lateral surface 820b of the second layer 820.

Thus, according to another embodiment of the present disclosure, the second lateral surface 820b of the second layer 820 is formed in the groove structure, whereby a second electrode 600, a first encapsulation layer 710, and a third encapsulation layer 730 provided on an upper surface of the damage preventing portion 800 are disconnected from a second electrode 600, a first encapsulation layer 710, and a third encapsulation layer 730 provided on some areas of the buffer area (BA) being not overlapped with the damage preventing portion 800, and more particularly, provided on a second upper surface 240b of an insulating interlayer 240 in the buffer area (BA). Thus, it is possible to prevent damages such as cracks, which might be generated in the camera area (CA), from extending to the display area (DA) via the buffer area (BA).

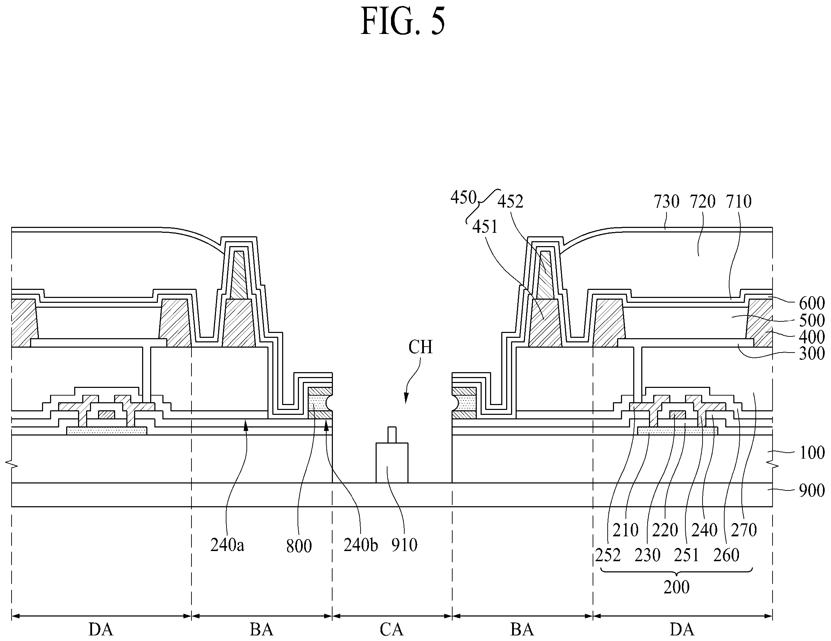

FIG. 5 is a rough cross-sectional view illustrating a display device according to another embodiment of the present disclosure, wherein a camera hole is formed by applying a laser cutting process to the display device of FIG. 2, and a camera is placed in the camera hole. Accordingly, the same reference numbers will be used throughout the drawings to refer to the same or like parts, and only different structures will be described in detail.

As shown in FIG. 5, a display area (DA) and a buffer area (BA) on a substrate 100 are the same as those of FIG. 2. However, a camera area (CA) on the substrate 100 is different from that of FIG. 2. In detail, the substrate 100, a gate insulating layer 220, an insulating interlayer 240, a second electrode 600, a first encapsulation layer 710, and a third encapsulation layer 730 provided in the camera area (CA) are removed by a laser cutting process.

Accordingly, the camera area (CA) is provided with a camera hole (CH) penetrating through the area from the substrate 100 to the third encapsulation layer 730, and a camera 910 is placed in the camera hole (CH). Thus, the camera 910 is provided while being confronted with the substrate 100 on the same plane as that of the substrate 100 in the buffer area (BA).

Also, a supporting portion 900 for supporting the camera 910 is provided below the substrate 100. The supporting portion 900 may be provided in the entire areas of the display area (DA), the buffer area (BA), and the camera area (CA). The supporting portion 900 may function as an external case

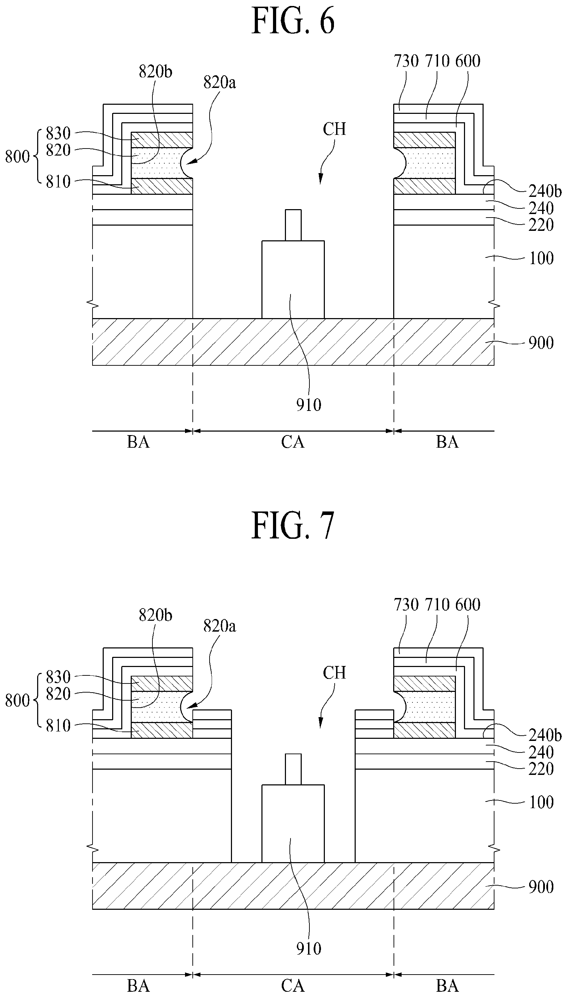

FIG. 6 is a rough cross-sectional view illustrating a buffer area and a camera area in a display device according to another embodiment of the present disclosure, which shows one case where a camera hole (CH) is formed by applying a laser cutting process to the display device with the damage preventing portion 800 of FIG. 3, and a camera 910 is placed in the camera hole

FIG. 7 is a rough cross-sectional view illustrating a buffer area and a camera area in a display device according to another embodiment of the present disclosure, which shows another case where a camera hole (CH) is formed by applying a laser cutting process to the display device with the damage preventing portion 800 of FIG. 3, and a camera 910 is placed in the camera hole

In case of FIG. 6, in the above display device with the damage preventing portion 800 of FIG. 3, a camera hole (CH) is configured to penetrate through the entire areas including a substrate 100, a gate insulating layer 220, an insulating interlayer 240, a second electrode 600, a first encapsulation layer 710, and a third encapsulation layer 730 in a camera area (CA).

Thus, referring to FIG. 6, the camera hole (CH) is formed in the entire camera area (CA), a camera 910 is placed in the camera hole (CH), and a supporting portion 900 for supporting the camera 910 is provided below the substrate 100. Accordingly, the damage preventing portion 800 provided in a buffer area (BA) is brought into contact with the camera hole (CH). Also, the camera 910 confronts the substrate 100 of the buffer area (BA).

Meanwhile, referring to FIG. 7, in the display device with the damage preventing portion 800 of FIG. 3, a camera hole (CH) is configured to penetrate through some areas of a substrate 100, a gate insulating layer 220, an insulating interlayer 240, a second electrode 600, a first encapsulation layer 710, and a third encapsulation layer 730 provided in a camera area (CA).

Thus, in case of FIG. 7, each of the substrate 100, the gate insulating layer 220, the insulating interlayer 240, the second electrode 600, the first encapsulation layer 710, and the third encapsulation layer 730 provided in the buffer area (BA) extends into the camera area (CA). That is, the above substrate 100, the gate insulating layer 220, the insulating interlayer 240, the second electrode 600, the first encapsulation layer 710, and the third encapsulation layer 730 extended to the camera area (CA) remain at least partly in the camera area (CA) without being removed by a laser cutting process.

Referring to FIG. 7, the camera hole (CH) is provided in some areas of the camera area (CA), a camera 910 is placed in the camera hole (CH), and a supporting portion 900 for supporting the camera 910 is provided below the substrate 100. Accordingly, the damage preventing portion 800 provided in a buffer area (BA) is not in contact with the camera hole (CH), and the substrate 100, the gate insulating layer 220, the insulating interlayer 240, the second electrode 600, the first encapsulation layer 710, and the third encapsulation layer 730 are provided between the damage preventing portion 800 and the camera hole (CH). Also, the camera 910 confronts the substrate 100 extended to the camera area (CA).

As described above in FIG. 6, if a processing error is generated under the condition that the camera hole (CH) is formed in the entire camera area (CA), the camera hole (CH) may invade the buffer area (BA). Thus, in case of FIG. 7, the camera area (CA) is designed to be larger than the camera hole (CH) in consideration of processing margin so that it is possible to prevent the invasion of the camera hole (CH) to the buffer area (BA).

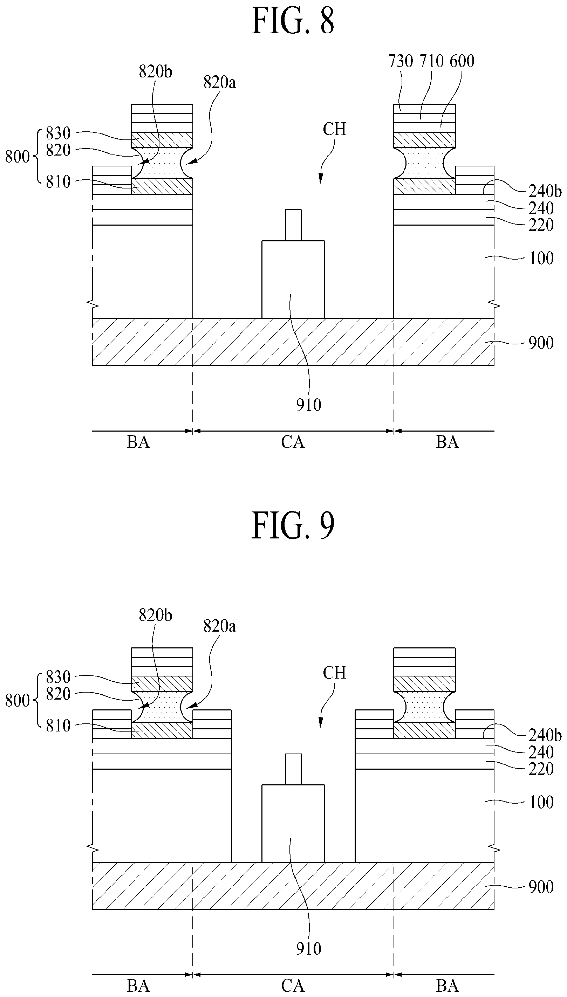

FIG. 8 is a rough cross-sectional view illustrating a buffer area and a camera area in a display device according to another embodiment of the present disclosure, which shows one case where a camera hole (CH) is formed by applying a laser cutting process to the display device with the damage preventing portion 800 of FIG. 4, and a camera 910 is placed in the camera hole.

FIG. 9 is a rough cross-sectional view illustrating a buffer area and a camera area in a display device according to another embodiment of the present disclosure, which shows another case where a camera hole (CH) is formed by applying a laser cutting process to the display device with the damage preventing portion 800 of FIG. 4, and a camera 910 is placed in the camera hole.

In case of FIG. 8, in the above display device with the damage preventing portion 800 of FIG. 4, a camera hole (CH) is configured to penetrate through entire areas of a substrate 100, a gate insulating layer 220, an insulating interlayer 240, a second electrode 600, a first encapsulation layer 710, and a third encapsulation layer 730 provided in a camera area (CA).

Thus, referring to FIG. 8, the camera hole (CH) is formed in the entire camera area (CA), a camera 910 is placed in the camera hole (CH), and a supporting portion 900 for supporting the camera 910 is provided below the substrate 100. Accordingly, the damage preventing portion 800 provided in a buffer area (BA) is brought into contact with the camera hole (CH). Also, the camera 910 confronts the substrate 100 of the buffer area (BA).

Meanwhile, referring to FIG. 9, in the display device with the damage preventing portion 800 of FIG. 4, a camera hole (CH) is configured to penetrate through some areas of a substrate 100, a gate insulating layer 220, an insulating interlayer 240, a second electrode 600, a first encapsulation layer 710, and a third encapsulation layer 730 provided in a camera area (CA).

Thus, in case of FIG. 9, each of the substrate 100, the gate insulating layer 220, the insulating interlayer 240, the second electrode 600, the first encapsulation layer 710, and the third encapsulation layer 730 provided in the buffer area (BA) extends to the camera area (CA). That is, the above substrate 100, the gate insulating layer 220, the insulating interlayer 240, the second electrode 600, the first encapsulation layer 710, and the third encapsulation layer 730 extended to the camera area (CA) remain at least partly in the camera area (CA) without being removed by a laser cutting process.

Referring to FIG. 9, the camera hole (CH) is provided in some areas of the camera area (CA), a camera 910 is placed in the camera hole (CH), and a supporting portion 900 for supporting the camera 910 is provided below the substrate 100. Accordingly, the damage preventing portion 800 provided in a buffer area (BA) is not in contact with the camera hole (CH), and the substrate 100, the gate insulating layer 220, the insulating interlayer 240, the second electrode 600, the first encapsulation layer 710, and the third encapsulation layer 730 are provided between the damage preventing portion 800 and the camera hole (CH). Also, the camera 910 confronts the substrate 100 extended to the camera area (CA) and/or is surrounded at least partly by the substrate 100.

As described above in FIG. 8, if a processing error is generated under the condition that the camera hole (CH) is formed in the entire camera area (CA), the camera hole (CH) may invade the buffer area (BA). Thus, in case of FIG. 9, the camera area (CA) is designed to be larger than the camera hole (CH) in consideration of processing margin so that it is possible to prevent the invasion of the camera hole (CH) to the buffer area (BA).

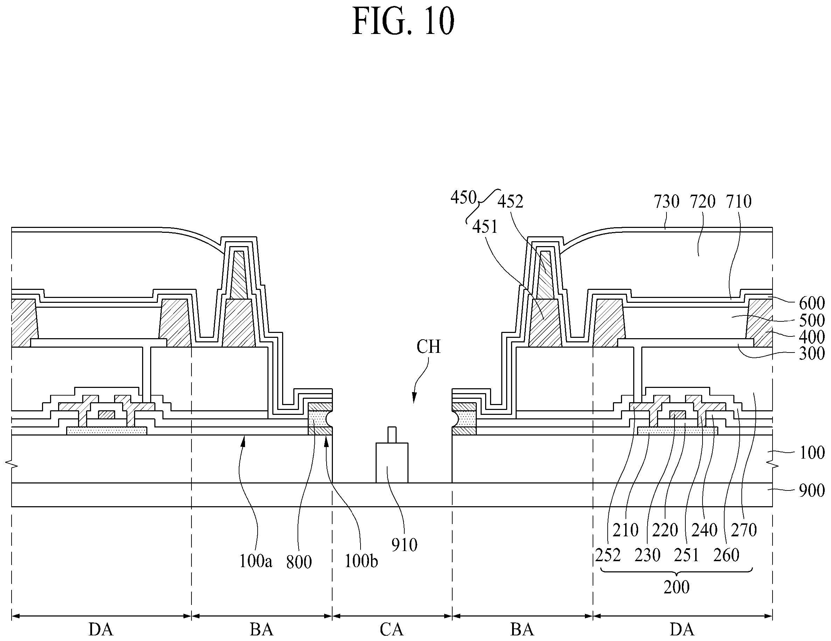

FIG. 10 is a rough cross-sectional view illustrating a display device according to another embodiment of the present disclosure. Except a position of a damage preventing portion 800, the display device of FIG. 10 is identical in structure to the display device of FIG. 5. Accordingly, the same reference numbers will be used throughout the drawings to refer to the same or like parts, and only different structures will be described in detail.

Referring to above FIG. 5, the damage preventing portion 800 is brought into contact with the second upper surface 240b of the insulating interlayer 240. Meanwhile, in case of FIG. 10, the damage preventing portion 800 is brought into contact with a second upper surface 100b of a substrate 100.

That is, referring to FIG. 10, a gate insulating layer 220, an insulating interlayer 240, a passivation layer 260, and a planarization layer 270 are provided in some areas of a buffer area (BA), and not provided in the remaining areas of the buffer area (BA). Thus, a first upper surface 100a of the substrate 100 in the buffer area (BA) is covered by the gate insulating layer 220, the insulating interlayer 240, the passivation layer 260, and the planarization layer 270, however, the second upper surface 100b of the substrate 100 in the buffer area (BA) is exposed without being covered by the gate insulating layer 220, the insulating interlayer 240, the passivation layer 260, and the planarization layer 270. Accordingly, the damage preventing portion 800 is formed on the second upper surface 100b of the substrate 100.

In the structure of FIG. 10, the gate insulating layer 220 and the insulating interlayer 240 are not provided in the camera area (CA) before a laser cutting process so that it is possible to smoothly perform the laser cutting process with easiness.

Although not shown in detail, the structures of the buffer area (BA) and the camera area (CA) shown in FIGs. 6 to 8 may be identically applied to the structure of FIG. 10.

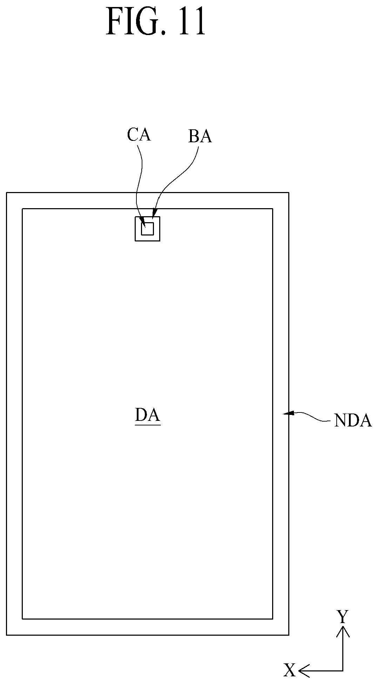

FIGs. 11 to 13 are rough plane views illustrating display devices according to various embodiments of the present disclosure. A structure of a camera area (CA) and a buffer area (BA) on the plane shown in FIGs. 11 to 13 is different from that of FIG. 1.

Referring to above FIG. 1, the camera area (CA) is formed in the circle shape, the buffer area (BA) is formed in the circular doughnut or tube shape to surround the camera area (CA).

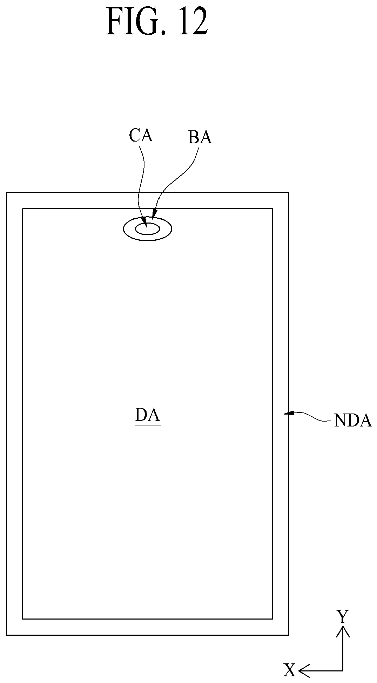

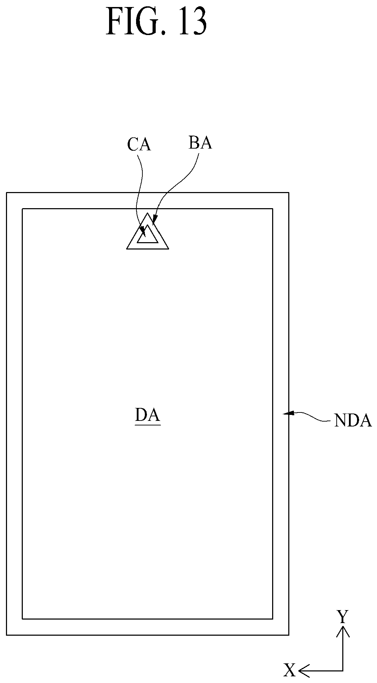

Meanwhile, in case of FIG. 11, the camera area (CA) is formed in a rectangular shape, and the buffer area (BA) is formed in a rectangular doughnut or tube shape to surround the camera area (CA). Also, in case of FIG. 12, the camera area (CA) is formed in an oval shape, and the buffer area (BA) is formed in an oval-type doughnut or tube shape to surround the camera area (CA). Also, in case of FIG. 13, the camera area (CA) is formed in a triangular shape, and the buffer area (BA) is formed in a triangular doughnut or tube shape to surround the camera area (CA). Although not shown, the camera area (CA) is formed in a pentagonal or polygonal shape, and the buffer area (BA) is formed in a pentagonal or polygonal doughnut or tube shape to surround the camera area (CA).

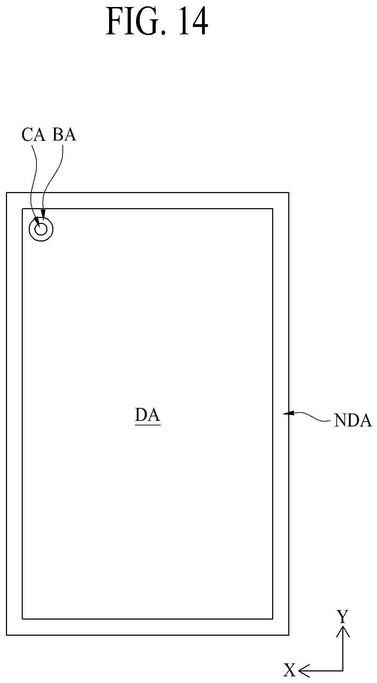

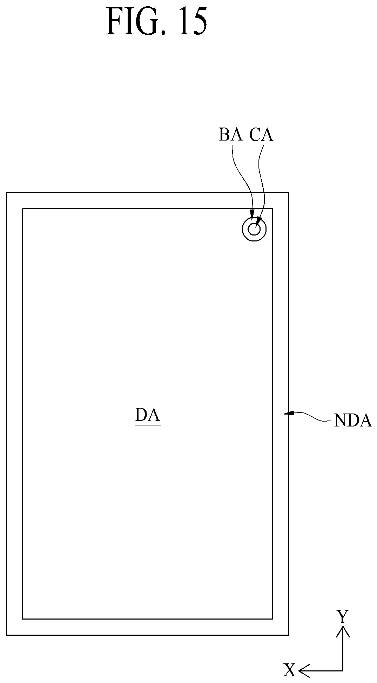

FIGs. 14 and 15 are rough plane views illustrating display devices according to various embodiments of the present disclosure. A position of a camera area (CA) and a buffer area (BA) on the plane shown in FIGs. 11 to 13 is different from that of FIG. 1.

In case of FIG. 14, the camera area (CA) and the buffer area (BA) are positioned between the center of the display area (DA) and the left end of the display area (DA) with respect to the X-axis of the display area (DA) on the plane, and more particularly, are positioned to be close to the left end of the display area (DA). In this respect, the position of the camera area (CA) and the buffer area (BA) shown in FIG. 14 is different from that of FIG. 1.

In case of FIG. 15, the camera area (CA) and the buffer area (BA) are positioned between the center of the display area (DA) and the right end of the display area (DA) with respect to the X-axis of the display area (DA) on the plane, and more particularly, are positioned to be close to the right end of the display area (DA). In this respect, the position of the camera area (CA) and the buffer area (BA) shown in FIG. 15 is different from that of FIG. 1.

In addition to the above cases of FIGs. 14 and 15, the position of the camera area (CA) and the buffer area (BA) may be changed in various methods and/or positions while being surrounded by the display area (DA).

Meanwhile, according as the camera area (CA) and the buffer area (BA) surrounding the camera area (CA) are prepared inside the display area (DA), the buffer area (BA) and the camera area (CA) are surrounded by the display area (DA), but not limited to this structure. For example, the camera area (CA) and the buffer area (BA) surrounding the camera area (CA) may be prepared inside the non-display area (NDA), whereby the buffer area (BA) and the camera area (CA) may be surrounded by the non-display area (NDA).

Even though the buffer area (BA) and the camera area (CA) are surrounded by the non-display area (NDA), the structure in each of the buffer area (BA) and the camera area (CA) may be the same as that of the aforementioned embodiments

In addition to the effects of the present disclosure as mentioned above, additional advantages and features of the present disclosure will be clearly understood by those skilled in the art from the above description of the present disclosure. It will be apparent to those skilled in the art that the present disclosure described above is not limited by the above-described embodiments and the accompanying drawings and that various substitutions, modifications, and variations can be made in the present disclosure without departing from the scope of the disclosures. Consequently, the scope of the present disclosure is defined by the accompanying claims.

## Claims

1. A display device comprising:
a hole area (CA);
a buffer area (BA) configured to at least partly surround the hole area (CA); and
a display area (DA) configured to surround the buffer area (BA),
wherein the display area (DA) includes at least one of a source electrode (251) and a drain electrode (252) of a thin film transistor (200) which are provided on an insulating interlayer (240),
wherein the buffer area (BA) includes a damage preventing portion (800) configured to prevent damages generated in a process of forming the hole area (CA) from extending to the display area (DA), and wherein the damage preventing portion (800) is formed of the same material as that of the source and drain electrodes (251, 252) and is provided on the insulating interlayer (240),
wherein the damage preventing portion (800) is provided in a same layer as that of the source electrode (251) and drain electrode (252) of the display area (DA),
wherein the damage preventing portion (800) includes a first layer (810), a second layer (820) on the first layer (810), and a third layer (830) on the second layer (820), and wherein each of the source electrode (251) and the drain electrode (252) has a three-layered structure in the same manner as the damage preventing portion (800).

2. The display device according to claim 1, wherein the damage preventing portion (800) is contacting the insulating interlayer (240) located between the substrate (100) of the display device and the damage preventing portion (800).

3. The display device according to claim 2, wherein a first lateral surface (820a) of the second layer (820) confronting the hole area (CA) is formed in a groove structure toward a direction of the buffer area (BA) and/or a second lateral surface (820b) of the second layer (820) is formed in a groove structure toward a direction being closer to the hole area (CA).

4. The display device according to claim 3, wherein a width between the first lateral surface (820a) of the second layer (820) and a second lateral surface (820b) corresponding to an opposite lateral surface to the first lateral surface (820a) of the second layer (820) is gradually decreased as it goes from its upper portion to its central portion, and/or is then gradually increased as it goes from its central portion to its lower portion.

5. The display device according to any one of the preceding claims 2-4, wherein a thickness in the second layer (820) is larger than a thickness of the first layer (810) and/or the third layer (830).

6. The display device according to any one of the preceding claims, wherein a camera (910) is provided in the hole area (CA).

7. The display device according to any one of the preceding claims, wherein the hole area (CA) is provided in the center with respect to a first axis of the display area (DA) on the plane or the hole area (CA) is provided to be close to one end of the display area (DA) in an area between a center of the display area (DA) and the one end of the display area (DA) with respect to a first axis of the display area (DA) on the plane.

8. The display device according to any one of the preceding claims, wherein the buffer area (BA) includes a substrate (100), at least one inorganic insulating layer (220, 240, 260) on the substrate (100), an organic insulating layer (270) on the at least one inorganic insulating layer (220, 240, 260), an electrode (600) on the organic insulating layer (270), and an encapsulation layer (710, 720, 730) on the electrode (600), and the electrode (600) and the encapsulation layer (710, 720, 730) are provided on the damage preventing portion (800), and/or the damage preventing portion (800) is not overlapped with the organic insulating layer (270).

9. The display device according to claim 8, wherein the buffer area (BA) further includes a dam structure (450) provided on the organic insulating layer (270).

10. The display device according to claim 8 or 9, wherein the encapsulation layer (710, 720, 730) includes a first encapsulation layer (710), a second encapsulation layer (720) on the first encapsulation layer (710), and a third encapsulation layer (730) on the second encapsulation layer (720), preferably a lower surface of the third encapsulation layer (730) is in contact with an upper surface of the first encapsulation layer (710) in the overlap area between the encapsulation layer and the dam structure (450) and/or in the area of the dam structure (450).

11. The display device according to any one of the claims 9 or 10, wherein the dam structure (450) includes a first dam structure (451), and a second dam structure (452) on the first dam structure (451), and/or the first dam structure (451) is provided at the same height as that of a bank (400) provided in the display area (DA), and/or is formed of the same material as that of the bank (400) provided in the display area (DA).

12. The display device according to any one of the preceding claims, wherein the damage preventing portion (800) is in contact with the hole area (CA) or extends into the hole area (CA).

13. The display device according to any one of the preceding claims, further comprising at least one of a substrate (100), an electrode (600) on the substrate (100), and an encapsulation layer (710, 730) on the electrode (600) additionally provided in an area between the damage preventing portion (800) and the hole area (CA).

14. The display device according to any one of the preceding claims, wherein the hole area (CA) is formed in any one of a circular shape, an oval shape, or a polygonal shape on the plane, and/or the buffer area (BA) is formed in any one of a circular doughnut shape, an oval-type doughnut shape, or a polygonal doughnut shape.

15. The display device according to any one of the preceding claims, wherein the buffer area (BA) includes an inorganic insulating layer (220, 240) on the substrate (100), an organic insulating layer (270) on the inorganic insulating layer 220, 240), an electrode (600) on the organic insulating layer (270), and an encapsulation layer (710, 730) on the electrode (600), wherein the damage preventing portion (800) is not overlapped with the organic insulating layer (270), and the electrode (600) and the encapsulation layer (710, 730) are provided on the damage preventing portion (800).

## Patentansprüche

1. Anzeigevorrichtung, die umfasst:
einen Lochbereich (CA);
einen Pufferbereich (BA), der so konfiguriert ist, dass er den Lochbereich (CA) zumindest teilweise umgibt; und
einen Anzeigebereich (DA), der so konfiguriert ist, dass er den Pufferbereich (BA) umgibt,
wobei der Anzeigebereich (DA) eine Source-Elektrode (251) und/oder eine Drain-Elektrode (252) eines Dünnschichttransistors (200) enthält, die auf einer Isolierzwischenschicht (240) vorgesehen sind,
wobei der Pufferbereich (BA) einen Schadenverhinderungsabschnitt (800) enthält, der konfiguriert ist, zu verhindern, dass sich Schäden, die in einem Vorgang des Bildens des Lochbereichs (CA) erzeugt werden, in den Anzeigebereich (DA) ausdehnen, und wobei der Schadenverhinderungsabschnitt (800) aus demselben Material wie das der Source- und der Drain-Elektrode (251, 252) gebildet ist und auf der Isolierzwischenschicht (240) vorgesehen ist,
wobei der Schadenverhinderungsabschnitt (800) in derselben Schicht wie jene der Source-Elektrode (251) und der Drain-Elektrode (252) des Anzeigebereichs (DA) vorgesehen ist,
wobei der Schadenverhinderungsabschnitt (800) eine erste Schicht (810), eine zweite Schicht (820) auf der ersten Schicht (810) und eine dritte Schicht (830) auf der zweiten Schicht (820) enthält und wobei die Source-Elektrode (251) und die Drain-Elektrode (252) eine Drei-Schichten-Struktur in derselben Weise wie der Schadenverhinderungsabschnitt (800) besitzen.

2. Anzeigevorrichtung nach Anspruch 1, wobei der Schadenverhinderungsabschnitt (800) die Isolierzwischenschicht (240), die sich zwischen dem Substrat (100) der Anzeigevorrichtung und dem Schadenverhinderungsabschnitt (800) befindet, kontaktiert.

3. Anzeigevorrichtung nach Anspruch 2, wobei eine erste laterale Fläche (820a) der zweiten Schicht (820), die sich gegenüber dem Lochbereich (CA) befindet, in einer Rillenstruktur in Richtung des Pufferbereichs (BA) gebildet ist und/oder eine zweite laterale Fläche (820b) der zweiten Schicht (820) in einer Rillenstruktur in einer Richtung, die näher an dem Lochbereich (CA) ist, gebildet ist.

4. Anzeigevorrichtung nach Anspruch 3, wobei eine Breite zwischen der ersten lateralen Fläche (820a) der zweiten Schicht (820) und einer zweiten lateralen Fläche (820b), die einer zu der ersten lateralen Fläche (820a) der zweiten Schicht (820) gegenüberliegenden lateralen Fläche entspricht, in Richtung von ihrem oberen Teil zu ihrem mittleren Teil allmählich abnimmt und/oder dann in Richtung von ihrem mittleren Teil zu ihrem unteren Teil allmählich zunimmt.

5. Anzeigevorrichtung nach einem der vorhergehenden Ansprüche 2-4, wobei eine Dicke der zweiten Schicht (820) größer als eine Dicke der ersten Schicht (820) und/oder der dritten Schicht (830) ist.

6. Anzeigevorrichtung nach einem der vorhergehenden Ansprüche, wobei in dem Lochbereich (CA) eine Kamera (910) vorgesehen ist.

7. Anzeigevorrichtung nach einem der vorhergehenden Ansprüche, wobei der Lochbereich (CA) in dem Mittelpunkt in Bezug auf eine erste Achse des Anzeigebereichs (DA) auf der Ebene vorgesehen ist oder der Lochbereich (CA) so vorgesehen ist, dass er nah an einem Ende des Anzeigebereichs (DA) in einem Bereich zwischen einem Mittelpunkt des Anzeigebereichs (DA) und dem einen Ende des Anzeigebereichs (DA) in Bezug auf eine erste Achse des Anzeigebereichs (DA) auf der Ebene vorgesehen ist.

8. Anzeigevorrichtung nach einem der vorhergehenden Ansprüche, wobei der Pufferbereich (BA) ein Substrat (100), mindestens eine anorganische Isolierschicht (220, 240, 260) auf dem Substrat (100), eine organische Isolierschicht (270) auf der mindestens einen anorganischen Isolierschicht (220, 240, 260), eine Elektrode (600) auf der organischen Isolierschicht (270) und eine Einkapselungsschicht (710, 720, 730) auf der Elektrode (600) enthält und die Elektrode (600) und die Einkapselungsschicht (710, 720, 730) auf dem Schadenverhinderungsabschnitt (800) vorgesehen sind und/oder sich der Schadenverhinderungsabschnitt (800) nicht mit der organischen Isolierschicht (270) überschneidet.

9. Anzeigevorrichtung nach Anspruch 8, wobei der Pufferbereich (BA) ferner eine Dammstruktur (450) enthält, die auf der organischen Isolierschicht (270) vorgesehen ist.

10. Anzeigevorrichtung nach Anspruch 8 oder 9, wobei die Einkapselungsschicht (710, 720, 730) eine erste Einkapselungsschicht (710), eine zweite Einkapselungsschicht (720) auf der ersten Einkapselungsschicht (710) und eine dritte Einkapselungsschicht (730) auf der zweiten Einkapselungsschicht (720) enthält, wobei eine untere Fläche der dritten Einkapselungsschicht (730) vorzugsweise mit einer oberen Fläche der ersten Einkapselungsschicht (710) in dem Überschneidungsbereich zwischen der Einkapselungsschicht und der Dammstruktur (450) und/oder in dem Bereich der Dammstruktur (450) in Kontakt ist.

11. Anzeigevorrichtung nach einem der Ansprüche 9 oder 10, wobei die Dammstruktur (450) eine erste Dammstruktur (451) und eine zweite Dammstruktur (452) auf der ersten Dammstruktur (451) enthält und/oder die erste Dammstruktur (451) auf derselben Höhe wie jene einer Bank (400), die in dem Anzeigebereich (DA) vorgesehen ist, vorgesehen ist und/oder aus demselben Material wie jenes der Bank (400), die in dem Anzeigebereich (DA) vorgesehen ist, gebildet ist.

12. Anzeigevorrichtung nach einem der vorhergehenden Ansprüche, wobei der Schadenverhinderungsabschnitt (800) mit dem Lochbereich (CA) in Kontakt ist oder sich in den Lochbereich (CA) erstreckt.

13. Anzeigevorrichtung nach einem der vorhergehenden Ansprüche, die ferner ein Substrat (100) und/oder eine Elektrode (600) auf dem Substrat (100) und/oder eine Einkapselungsschicht (710, 730) auf der Elektrode (600) umfasst, die zusätzlich in einem Bereich zwischen dem Schadenverhinderungsabschnitt (800) und dem Lochbereich (CA) vorgesehen sind.

14. Anzeigevorrichtung nach einem der vorhergehenden Ansprüche, wobei der Lochbereich (CA) in einer Kreisform oder einer ovalen Form oder einer Polygonform auf der Ebene gebildet ist und/oder der Pufferbereich (BA) in einer kreisförmigen Donut-Form, einer Donut-Form vom ovalen Typ oder einer polygonalen Donut-Form gebildet ist.

15. Anzeigevorrichtung nach einem der vorhergehenden Ansprüche, wobei der Pufferbereich (BA) eine anorganische Isolierschicht (220, 240) auf dem Substrat (100), eine organische Isolierschicht (270) auf der anorganischen Isolierschicht (220, 240), eine Elektrode (600) auf der organischen Isolierschicht (270) und eine Einkapselungsschicht (710, 730) auf der Elektrode (600) enthält, wobei sich der Schadenverhinderungsabschnitt (800) nicht mit der organischen Isolierschicht (270) überschneidet und die Elektrode (600) und die Einkapselungsschicht (710, 730) auf dem Schadenverhinderungsabschnitt (800) vorgesehen sind.

## Revendications

1. Dispositif d'affichage comportant :
une zone de trou (CA) ;
une zone de tampon (BA) configurée pour entourer au moins partiellement la zone de trou (CA) ; et
une zone d'affichage (DA) configurée pour entourer la zone de tampon (BA),
dans lequel la zone d'affichage (DA) inclut au moins une électrode parmi une électrode de source (251) et une électrode de drain (252) d'un transistor à couches minces (200) qui sont disposées sur une couche intercalaire isolante (240),
dans lequel la zone de tampon (BA) inclut une partie de prévention de dommages (800) configurée pour empêcher des dommages générés dans un processus de formation de la zone de trou (CA) de s'étendre jusqu'à la zone d'affichage (DA), et dans lequel la partie de prévention de dommages (800) est formée du même matériau que celui des électrodes de source et de drain (251, 252) et est disposée sur la couche intercalaire isolante (240),
dans lequel la partie de prévention de dommages (800) est disposée dans une même couche que celle de l'électrode de source (251) et de l'électrode de drain (252) de la zone d'affichage (DA),
dans lequel la partie de prévention de dommages (800) inclut une première couche (810), une deuxième couche (820) sur la première couche (810) et une troisième couche (830) sur la deuxième couche (820), et dans lequel chaque électrode parmi l'électrode de source (251) et l'électrode de drain (252) a une structure à trois couches de la même manière que la partie de prévention de dommages (800).

2. Dispositif d'affichage selon la revendication 1, dans lequel la partie de prévention de dommages (800) est en contact avec la couche intercalaire isolante (240) située entre le substrat (100) du dispositif d'affichage et la partie de prévention de dommages (800).

3. Dispositif d'affichage selon la revendication 2, dans lequel une première surface latérale (820a) de la deuxième couche (820) faisant face à la zone de trou (CA) est formée dans une structure de rainure vers une direction de la zone de tampon (BA) et/ou une seconde surface latérale (820b) de la deuxième couche (820) est formée dans une structure de rainure vers une direction qui est plus près de la zone de trou (CA).

4. Dispositif d'affichage selon la revendication 3, dans lequel une largeur entre la première surface latérale (820a) de la deuxième couche (820) et une seconde surface latérale (820b) correspondant à une surface latérale opposée à la première surface latérale (820a) de la deuxième couche (820) est graduellement réduite lorsqu'elle passe de sa partie supérieure à sa partie centrale, et/ou est ensuite augmentée graduellement lorsqu'elle passe de sa partie centrale à sa partie inférieure.

5. Dispositif d'affichage selon l'une quelconque des revendications 2 à 4 précédentes, dans lequel une épaisseur dans la deuxième couche (820) est supérieure à une épaisseur de la première couche (810) et/ou de la troisième couche (830).

6. Dispositif d'affichage selon l'une quelconque des revendications précédentes, dans lequel une caméra (910) est disposée dans la zone de trou (CA).

7. Dispositif d'affichage selon l'une quelconque des revendications précédentes, dans lequel la zone de trou (CA) est disposée au centre par rapport à un premier axe de la zone d'affichage (DA) sur le plan, ou la zone de trou (CA) est disposée de manière à être près d'une extrémité de la zone d'affichage (DA) dans une zone située entre un centre de la zone d'affichage (DA) et l'extrémité de la zone d'affichage (DA) par rapport à un premier axe de la zone d'affichage (DA) sur le plan.

8. Dispositif d'affichage selon l'une quelconque des revendications précédentes, dans lequel la zone de tampon (BA) inclut un substrat (100), au moins une couche isolante inorganique (220, 240, 260) sur le substrat (100), une couche isolante organique (270) sur la au moins une couche isolante inorganique (220, 240, 260), une électrode (600) sur la couche isolante organique (270), et une couche d'encapsulation (710, 720, 730) sur l'électrode (600), l'électrode (600) et la couche d'encapsulation (710, 720, 730) sont disposées sur la partie de prévention de dommages (800), et/ou la partie de prévention de dommages (800) ne chevauche pas la couche isolante organique (270).

9. Dispositif d'affichage selon la revendication 8, dans lequel la zone de tampon (BA) inclut en outre une structure de barrage (450) disposée sur la couche isolante organique (270).

10. Dispositif d'affichage selon la revendication 8 ou 9, dans lequel la couche d'encapsulation (710, 720, 730) inclut une première couche d'encapsulation (710), une deuxième couche d'encapsulation (720) sur la première couche d'encapsulation (710), et une troisième couche d'encapsulation (730) sur la deuxième couche d'encapsulation (720), une surface inférieure de la troisième couche d'encapsulation (730) étant de préférence en contact avec une surface supérieure de la première couche d'encapsulation (710) dans la zone de chevauchement entre la couche d'encapsulation et la structure de barrage (450) et/ou dans la zone de la structure de barrage (450).

11. Dispositif d'affichage selon l'une quelconque des revendications 9 ou 10, dans lequel la structure de barrage (450) inclut une première structure de barrage (451) et une seconde structure de barrage (452) sur la première structure de barrage (451), et/ou la première structure de barrage (451) est disposée à la même hauteur que celle d'un banc (400) disposé dans la zone d'affichage (DA), et/ou est formée du même matériau que celui du banc (400) disposé dans la zone d'affichage (DA).

12. Dispositif d'affichage selon l'une quelconque des revendications précédentes, dans lequel la partie de prévention de dommages (800) est en contact avec la zone de trou (CA) ou s'étend dans la zone de trou (CA).

13. Dispositif d'affichage selon l'une quelconque des revendications précédentes, comportant en outre au moins un élément parmi un substrat (100), une électrode (600) sur le substrat (100) et une couche d'encapsulation (710, 730) sur l'électrode (600) disposée de plus dans une zone entre la partie de prévention de dommages (800) et la zone de trou (CA).

14. Dispositif d'affichage selon l'une quelconque des revendications précédentes, dans lequel la zone de trou (CA) est formée dans une forme quelconque parmi une forme circulaire, une forme ovale ou une forme polygonale sur le plan, et/ou la zone de tampon (BA) est formée dans une forme quelconque parmi une forme d'anneau circulaire, une forme d'anneau de type ovale ou une forme de beignet polygonale.

15. Dispositif d'affichage selon l'une quelconque des revendications précédentes, dans lequel la zone de tampon (BA) inclut une couche isolante inorganique (220, 240) sur le substrat (100), une couche isolante organique (270) sur la couche isolante inorganique (220, 240), une électrode (600) sur la couche isolante organique (270), et une couche d'encapsulation (710, 730) sur l'électrode (600), dans lequel la partie de prévention de dommages (800) ne recouvre pas la couche isolante organique (270), et l'électrode (600) et la couche d'encapsulation (710, 730) sont agencées sur la partie de prévention de dommages (800).
